# EUROPEAN PATENT APPLICATION

(11) **EP 4 610 670 A2**
(43) Date of publication of application: **03.09.2025**
(21) Application number: 25160249.6
(22) Date of filing: 26.02.2025
(51) Int. Cl.: G01R 19/14, G01R 19/145, G01R 1/04

(54) **BAND**

(30) Priority: 29.02.2024 GB 202402913
(71) Applicant: GMC-I Prosys Ltd., Lancashire WN8 9PH (GB)
(72) Inventor: GOULDSON, Dean, Skelmersdale, WN8 9PH (GB)
(74) Representative: Marks & Clerk LLP

(57) **Abstract**

There is provided a property band 18 that is mountable to a measurement sensor 2. The measurement sensor 2 is for determining one or more characteristics of a conductor 74. The measurement sensor 2 comprises a housing 4 and a cable 12. The property band 18 comprises a body 20 that is configured to be mounted to the housing 4 of the measurement sensor 2. The body 20 comprises a coupling 32. In a first configuration of the coupling 32, the body 20 is mountable to, or removable from, the housing 4. In a second configuration of the coupling 32, removal of the body 20 from the housing 4 is prevented.

## Description

### Field of Invention

The present invention relates to a property band, a measurement sensor, and to a method.

### Background

Measurement sensors are used for a variety of applications. Certain measurement sensors are available in a variety of specifications, each being intended for a particular purpose. Each of the specifications may appear, from the outside, to be identical to the other specifications. One example of such a measurement sensor is a Rogowski coil. Rogowski coils comprise a housing and a cable. Rogowski coils are often supplied in three or four, such that three phase plus neutral electricity supply can be measured - one by each sensor. Each of the three or four sensors are provided with a different colour cable to identify the relevant sensor for its respective phase of electricity supply.

It is an object of the present invention to address one or more problems associated with the prior art, whether identified herein or otherwise.

### Summary

In a first aspect of the invention there is provided a property band that is mountable to a measurement sensor. The measurement sensor is for determining one or more characteristics of a conductor. The measurement sensor comprises a housing and a cable. The property band comprises a body that is configured to be mounted to the housing of the measurement sensor. The body comprises a coupling. In a first configuration of the coupling, the body is mountable to, or removable from, the housing. In a second configuration of the coupling, removal of the body from the housing is prevented.

In the second configuration of the coupling, removal of the body from the housing may be prevented when the body is mounted to the housing.

The measurement sensor may be a Rogowski coil.

Measurement sensors are typically suitable to be used to measure one or more characteristics of a conductor having a particular property or particular properties.

Conventionally, measurement sensors are identified as being suitable for use with a particular conductor by virtue of, for example, a colour of the cable. However, this is inefficient because a number of different coloured cables need to be sourced and stocked. The present invention allows a single colour cable to be used for a variety of different measurement sensors because the property band can indicate one or more properties of the conductor. This advantageously improves the efficiency of manufacture of the measurement sensor. Furthermore, operational efficiency is improved for the user because less cable stock needs to be held.

A further benefit of the invention is that, since the cable of the measurement sensor need not be a particular colour, only one pigment is required to manufacture the cable. This therefore reduces the environmental impact of the measurement sensor.

In addition, the coupling allows for simple mounting and removal of the property band to and from the measurement sensor. This improves the user friendliness of the property band.

The property band may further comprise a coupling member. In the second configuration, the coupling may be configured to receive the coupling member to prevent removal of the body from the housing.

Where provided, the coupling member retains the coupling in the second configuration in a robust manner.

The coupling member may be said to form a part of the coupling.

The coupling member may be configured to secure the body to the conductor.

In the second configuration, the coupling member may be configured to secure the body to the conductor.

The coupling member being configured to secure the body to the conductor may be understood to mean that the coupling member is configured to secure the position of the body with respect to the conductor.

The coupling member may be configured to be secured to the conductor.

Where the coupling member is configured to both prevent removal of the body from the housing, and to secure the body to the conductor, use of the property band and of the measurement sensor is advantageously more user friendly. This is because a single coupling member serves two purposes in use, and so fewer steps are required to mount the measurement sensor to a conductor.

The coupling member and coupling may together define a poka-yoke mechanism.

The coupling member and coupling together defining a poka-yoke mechanism may be understood to mean that the coupling member can only be received by the coupling when the coupling member is inserted into the coupling in a predetermined direction.

Where the coupling member and coupling together define a poka-yoke mechanism, the likelihood of human error in insertion of the coupling member into the coupling is advantageously reduced. This makes assembly of the property band onto the housing more efficient.

The body may comprise a base portion, a first arm that extends from the base portion, and a second arm that extends from the base portion.

The coupling may comprise a first coupling portion and a second coupling portion.

The first coupling portion may be disposed at a first arm distal end. The second coupling portion may be disposed at a second arm distal end.

The first coupling portion may comprise a first channel. The second coupling portion may define a second channel.

The second coupling portion may define a first end and a second end. The second channel may taper between the first end and the second end.

The first coupling portion may define a first end and a second end. The first channel may taper between the first end and the second end.

A first end opening of the channel, disposed at the first end of the first coupling portion, may be larger than a second end opening of the channel, disposed at the second end of the first coupling portion. The first end opening being larger than the second end opening may be understood to refer to the first end opening having a larger area and/or thickness than the second end opening.

The coupling member may be in the form of a plug. A first end of the plug may be receivable by the first coupling portion. A second end of the plug may be receivable by the second coupling portion.

A shape of the first end of the plug may correspond to a shape of the first channel.

The plug may comprise a central portion. The central portion may comprise a protrusion. A thickness of the plug at the protrusion may be equal to or greater than a thickness of the second opening of the first coupling portion.

The thickness of the plug at the protrusion may refer to a maximum thickness of the plug.

Put another way, the protrusion may be said to be able to pass through the second opening via an interference fit.

When received by the coupling, the protrusion may be disposed between the first coupling portion and the second coupling portion.

Advantageously, this better retains the plug within the coupling.

In the second configuration of the coupling, a first channel central axis may be generally coaxial a second channel central axis.

Advantageously, this allows for easier insertion of the coupling member.

The body may be formed from a resilient material.

Where the body is formed from a resilient material, mounting of the property band onto the housing is advantageously simplified. The property band can be mounted onto the housing with minimal manipulation by the user.

The property band may provide an indication of a phase of the conductor. The property band may provide a visual indication of the phase of the conductor.

Where the property band provides a indication of a phase of the conductor, a user can readily determine whether the property band is appropriate for a given measurement sensor or conductor.

A colour of the body of the property band may provide an indication of the phase of the conductor.

Where the colour of the body of the property band provides an indication of the phase of the conductor, error in selection of a property band for a given measurement sensor, or in selection of a measurement sensor (to which a property band is mounted) for a given conductor is reduced.

The property band may provide a visual indication of a polarity of a conductor.

Where the property band provides a visual indication of a polarity of the conductor, the user friendliness of the measurement sensor is improved. This is because the user is able to readily determine the appropriate orientation of the measurement sensor with respect to the conductor.

In a second aspect of the invention there is provided a measurement sensor for measuring one or more characteristics of a conductor. The measurement sensor comprises a cable. The cable has a first end that extends from the housing and a free second end. The measurement sensor further comprise a housing that comprises a socket. The first end of the cable extends from the housing and the free second end of the cable is receivable by the socket. The measurement sensor further comprises a property band according to the first aspect of the invention. The property band is disposed about the housing.

The advantages discussed above with respect to the first aspect of the invention apply to this aspect.

In a third aspect of the invention there is provided a method. The method comprises providing an electricity supply that comprises a plurality of conductor; providing a measurement sensor that comprises a housing and a cable; determining one or more properties of a conductor of the plurality of conductors; mounting a property band to the housing of the measurement sensor, the property band being associated with the one or more properties of the conductor; and securing the property band to the housing.

The advantages discussed above with respect to the first aspect of the invention apply to this aspect.

Securing the property band to the housing may also secure the property band to the conductor.

Securing the property band to the housing may also secure the housing of the property band to the conductor.

Features disclosed in relation to one aspect of the invention may be combined with another as appropriate.

### Brief Description of the Drawings

Embodiments of the present invention will now be described with reference to the accompanying drawings, in which:
Figure 1 shows a measurement sensor comprising a property band;
Figure 2 shows a perspective view of the property band of Figure 1;
Figure 3 shows a bottom view of the property band of Figure 2
Figures 4a and 4b show a coupling of the property band of Figure 2;
Figures 5a to 6b show a process for mounting the property band of Figures 2 and 3 onto the measurement sensor of Figure 1; and
Figures 7a and 7b show a measurement sensor comprising a property band according to a second embodiment.

### Detailed Description

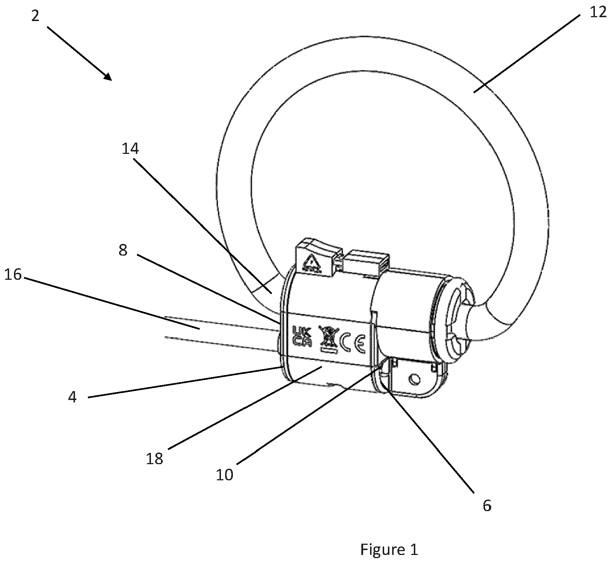

Figure 1 shows a measurement sensor 2. The measurement sensor 2 is for measuring alternating current and/or high speed electrical current pulses of a conductor (not shown). The measurement sensor 2 is a Rogowski coil. However, it will be appreciated that the present teachings are applicable to other types of measurement sensors. The measurement sensor 2 comprises a housing 4. Sensor circuitry may be disposed in the housing 4. The housing 4 comprises a body 6. The body 6 may be referred to as a main body. The body 6 comprises a first end 8 and a second end 10. The first end 8 is generally opposed to the second end 10. An integrator circuit (not visible - it is within the body 6) is disposed in the housing 4. In particular, the integrator circuit is disposed in the body 6 of the housing 4. However, in other embodiments, the integrator circuit need not be provided.

The measurement sensor 2 further comprises a cable 12. The cable 12 comprises a coil of wire (not visible in Figure 1 - it is disposed within the cable). The cable 12 comprises a first end 14. The cable 12 comprises a second end (not visible in Figure 1 - it is disposed within the housing 4). The second end of the cable 12 is free, and so the second end may be referred to as a free second end. The second end of the cable 12 is securable to the housing 4. In use, the cable 12 is passed around (i.e., wrapped around) a conductor and the second end of the cable 12 is secured to the housing 4. This the measurement sensor 2 the conductor. The first end 14 of the cable 12 extends from the housing 4. In particular, the first end 14 of the cable 12 extends from the first end 8 of the housing 4.

The measurement sensor 2 further comprises an output cable 16. The output cable 16 extends from the housing 4. In particular, the output cable 16 extends from the first end 12 of the housing 4. The output cable 16 is connectable to an external device (not shown) to provide readings obtained using the measurement sensor 2 to the external device.

The measurement sensor 2 further comprises a property band 18. The property band 18 may serve to indicate a phase and/or polarity of the conductor that is to be measured by the measurement sensor 2. The property band 18 may indicate the phase of the conductor by virtue of, for example, a colour of the property band 18. The property band 18 may also indicate a polarity of the conductor, as will be discussed in more detail below. The property band 18 is mounted to the housing 4. The property band 18 is mounted to the body 6 of the housing 4. The property band 18 is disposed about the housing 4.

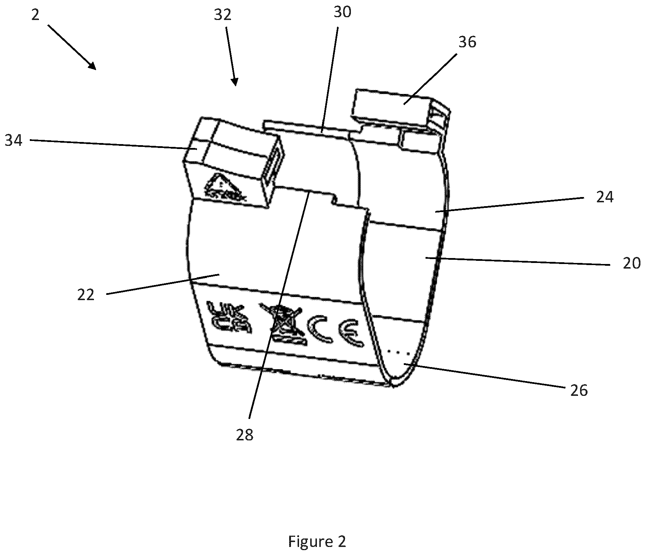

Referring now to Figure 2, which shows the property band 18 in isolation. The property band 18 comprises a body 20. The body 20 comprises a first arm 22 and a second arm 24. The body 20 comprises a base portion 26. The body 20 is formed from a resilient material. The entirety of the body 20 is formed from a resilient material. In some embodiments, only the base portion 26 need be formed from a resilient material, and the remainder of the body 20 can be formed from a rigid material. Therefore, only a portion of the body 20 need be formed from a resilient material. In some embodiments, the entirety of the body 20 can be formed from a rigid material. Where the entirety of the body 20 is formed from a rigid material, the base portion 26 may comprise a hinge. The first arm 22 comprises a first arm distal end 28. The second arm 24 comprises a second arm distal end 30.

The body 20 being formed from a resilient material allows body 20 to be deformed, or moved, between an open configuration, in which the first arm 22 and the second arm 24 are separated from one another, and a closed configuration in which the first arm distal end 28 and the second arm distal end 30 are disposed adjacent one another. In the open configuration, the body 20 of the property band 18 can be mounted to, or removed from, the housing of the measurement sensor (not shown).

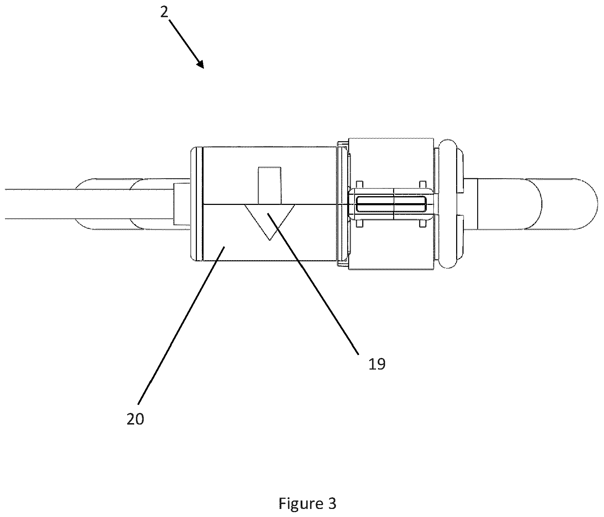

Referring to Figure 3 the body 20 comprises a polarity indication 19. The polarity indication 19 is in the form of a graphic. The polarity indication 19 is in the form of an arrow. The polarity indication 19 visually indicates the direction of conventional current flow within the conductor to which the measurement sensor (not shown in Figure 3) is mounted in use. The polarity of the conductor may be determined by a user prior to attaching the measurement sensor 2 to the conductor. The measurement sensor 2 can then be mounted to the conductor with an appropriate orientation such that the polarity of the conductor is correctly indicated by the polarity indication 19. This allows the polarity of the conductor to be readily determined by subsequent users.

Referring back to Figure 2. The body 20 comprises a coupling 32. In Figure 2, the coupling is in a first configuration. In the first configuration of the coupling 32, the body 20 of the property band 18 is in the open configuration. As will be discussed in more detail below, in the first configuration of the coupling 32, the body 20 of the property band 18 is mountable to, or removable from, the housing of the measurement sensor (not shown in Figure 2). In a second configuration of the coupling 32, discussed in more detail below, removal of the body 20 from the housing of the measurement sensor is prevented.

The coupling 32 comprises a first coupling portion 34 and a second coupling portion 36. The first coupling portion 34 is disposed at the first arm distal end 28. The second coupling portion 36 is disposed at the second arm distal end 30. The first coupling portion 34 is overhung beyond the first arm distal end 28. The second coupling portion 36 is overhung beyond the second arm distal end 30.

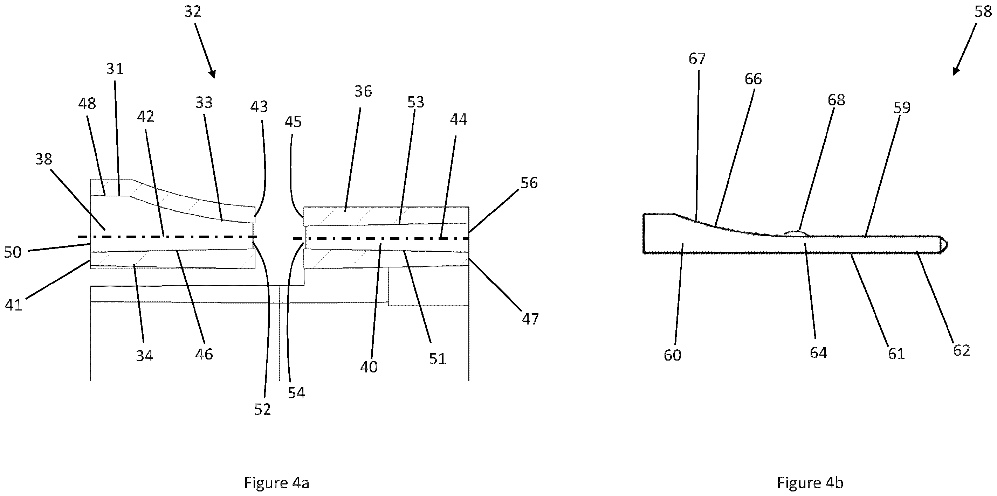

Referring now to Figures 4a and 4b. Figure 4a shows a cross sectional view taken through the coupling 32. The first coupling portion 34 comprises a first channel 38. The first channel 38 defines a first channel central axis 42. The first channel 38 is defined, at least in part, by a lower surface 46 and an upper surface 48. The first coupling portion 34 comprises a first end 41 and a second end 43. The first channel 38 comprises a first end opening 50 and a second end opening 52. The first channel central axis 42 extends through a centre of area of the second end opening 52. The first channel central axis 42 extends perpendicular to a plane defined by the first end opening 50.

The first channel 38 tapers between the first end 41 and the second end 43 of the first coupling portion 34. This assists with insertion of a coupling member into the first coupling member 34. The first end opening 50 is larger than the second end opening 52 of the first channel 38. The first end opening 50 being larger than the second end opening 52 may be understood to refer to the first end opening 50 having a larger area and/or thickness than the second end opening 52. Here, the thickness of the first channel 38 refers to the distance between the lower surface 46 and the upper surface 48.

The upper surface 48 of the first channel 38 is tapered. Therefore, at the first end 41 of the first coupling portion 34, the distance from the upper surface 48 to the central axis 42 at the first end 41 of the first coupling portion 34 is greater than the distance from the upper surface 48 to the central axis 42 at the second end 43 of the first coupling portion 34. The upper surface 48 comprises a linear tapered portion 31. The linear tapered portion 31 is disposed at the first end 41. The upper surface 48 comprises a curved tapered portion 33. The curved tapered portion 33 is disposed at the second end 43 of the first coupling portion 34. In some embodiments, a portion of the upper surface 48, such as the portion adjacent the first end 41, need not be tapered (i.e., may extend parallel to the central axis 42). In some embodiments, the entirety of the upper surface 48 may define a linear taper, or a rounded taper that extends from the first end 41 of the first coupling portion 34 to the second end 43 of the first coupling portion 34.

The lower surface 46 of the first coupling portion 34 is tapered. At the first end 41 of the first coupling portion 34, the distance from the lower surface 46 to the first channel central axis 42 is greater than the distance from the lower surface 46 to the central axis 42 at the second end 43 of the first coupling portion 34. The lower surface 46 is linearly tapered from the first end 41 to the second end 43 of the first coupling portion 34. In some embodiments, the lower surface 46 may define a curved taper. In some embodiments, the lower surface 46 need not be tapered, and may extend parallel to the first channel central axis 42.

The second coupling portion 36 comprises a second channel 40. The second channel 40 defines a second channel central axis 44. The second coupling portion 36 comprises a first end 45 and a second end 47. The second channel 40 comprises a first end opening 54 and a second end opening 56. The thickness, and preferably the area, of the first end opening 54 of the second channel 40 is less than that of the second end opening 52 of the first channel 38 of the first coupling portion 34. In some embodiments, the thickness and/or area of the first end opening 54 of the second channel 38 of the second coupling portion 36 can be equal to or less than the area of the second end opening 52 of the second channel 40 of the first coupling portion 34. The second channel central axis 44 extends through a centre of area of the first end opening 54 and through a centre of area of the second end opening 56.

The second channel 40 tapers between the first end 45 and the second end 47 of the second coupling member 36. The thickness, and preferably area, of the first end opening 54 is less than that of the second end opening 56. This assists with manufacture of the second coupling member 36. In particular, where the second coupling member 36 is formed via injection moulding, the geometry of the second channel 40 assists with the flow of material during the injection stage, and with ejection of the second coupling member 36 from the mould following injection. The thickness of the second channel 40 is defined by the distance between a lower surface 51 and an upper surface 53. The upper surface 53 tapers linearly from the first end 45 to the second end 47 of the second coupling member 36. The lower surface 51 tapers linearly from the first end 45 to the second end 47 of the second coupling member 36. The distance from the lower surface 51 to the second channel central axis 44 at the first end 45 is less than the distance from the lower surface 51 to the second channel central axis 44 at the second end 47. The distance from the upper surface 53 to the second channel central axis 44 at the first end 45 is less than the distance from the upper surface 53 to the second channel central axis 44 at the second end 47. In some embodiments, the second channel 40 need not be tapered. In some embodiments, the upper surface 53 and/or lower surface 51 of the second channel 40 may define a curved tapered surface.

Figure 4b shows the coupling member 58 of the coupling 32. The coupling member 58 is receivable by first coupling portion 34 and the second coupling portion 36. In particular, the coupling member 58 is receivable by the first channel 38 of the first coupling portion 34 and by the second channel 40 of the second coupling portion 36. The coupling member 58 of this embodiment is in the form of a plug. The coupling member comprises a first end 60 and a second end 62. The coupling member 58 further comprises a central portion 64. The central portion 64 is disposed between the first end 60 and the second end 62. The coupling member 58 comprises an upper surface 59 and a lower surface 61.

The coupling member 58 and the coupling 32 together define a poka-yoke mechanism. That is to say, the coupling member 58 and coupling 32 are configured such that the coupling member 58 can only be received by the coupling 32 when the coupling member 58 is inserted into the coupling 32 in a predetermined direction. The thickness of the first end 60 is greater than the thickness of the second channel 40, in particular than the second end opening 56 of the second channel 40, of the second coupling member 36. This prevents insertion of the first end 60 of the coupling member 58 into the second coupling member 36. The shape of the first end 60 corresponds with the shape of the first channel 38 of the first coupling portion 34. The first end 60 defines a tapered portion 66. The tapered portion 66 defines a tapered surface 67. The tapered surface 67 forms a part of the upper surface 59. The first end, in particular the tapered portion 66 (and therefore the tapered surface 67) of the first end 60 corresponds in shape and size to the shape of the upper surface 48 of the first coupling portion 34. In use, as will be discussed in more detail below, the coupling member 58 is received by the first coupling portion and the second coupling portion. In some embodiments, the coupling member 58 need not be provided, and the first coupling portion 34 and the second coupling portion 36 may interlock with one another. In such embodiments, the coupling 32 is in the second configuration when the first coupling portion 34 and the second coupling portion 36 are interlocked with one another.

The coupling member 58 comprises a protrusion 68. The protrusion 68 is disposed at the central portion 64 of the coupling member 58. The protrusion 68 extends from the upper surface 59 of the coupling member 58. However, in some embodiments, the protrusion 68 can extend from the lower surface 61 of the coupling member 58. A thickness of the central portion 64 in the region of the protrusion 68 is equal to or greater than the thickness of the first channel 38 at the second end opening 52. This reduces the likelihood of the coupling member 58 inadvertently being removed from the coupling in use. The thickness of the central portion 64 in the region of the protrusion 68 is equal to or less than the thickness of the second channel 40 at the first end opening 54. Since the thickness and/or area of the first end opening 54 of the second channel 40 is less than the thickness and/or area of the second end opening 52 of the first channel, the likelihood of the protrusion entering the second channel is reduced.

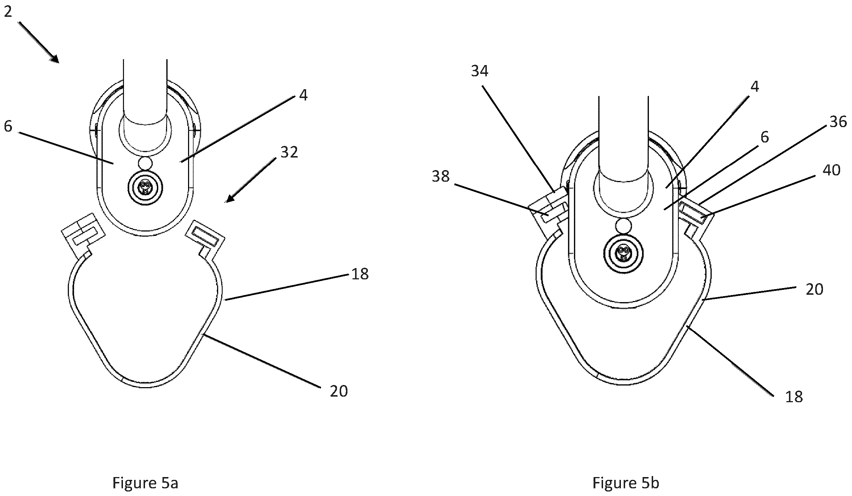

Mounting of the property band 18 on to the body 6 of the housing 4 of the measurement sensor 2 will now be discussed with reference to Figures 5a to 6b. A user may have a plurality of property bands 18 available to them. Each property band 18 may indicate a particular property of the conductor (not shown) that is to be measured by the measurement sensor. For example, each property band 18 may be associated with a conductor having a particular phase. Each property band 18 may indicate a property, such as a phase, of the conductor. The property may be indicated visually such as by a colour of the body 20 of the property bands 18. Before mounting the property band 18 onto the body 6 of the housing 4 of the measurement sensor 2, a user determines one or more properties of the conductor. The one or more properties may include a phase of the conductor. Once the user has determined one or more properties of the conductor, a property band associated with that property is selected. The user then begins mounting of the property band 18 onto the housing 4 of the measurement sensor 2.

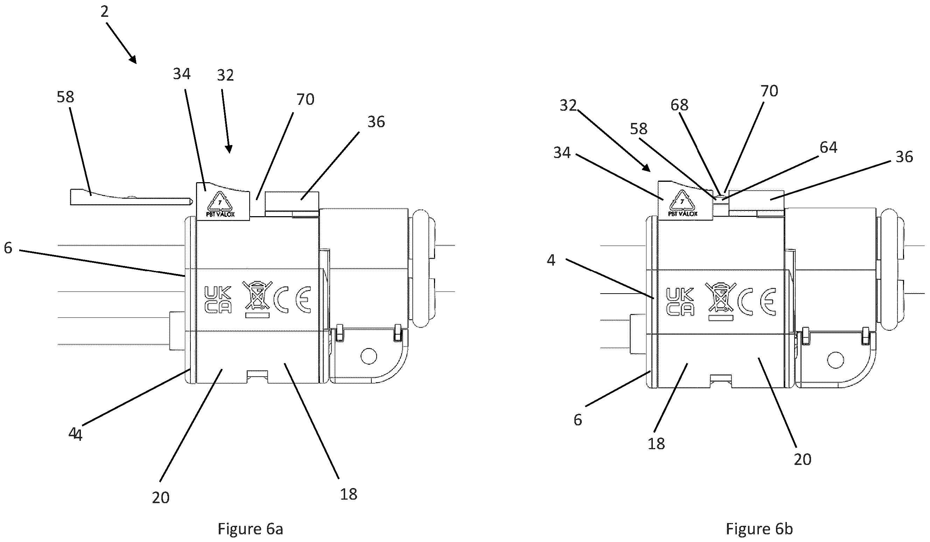

The body 20 of the property band 18 is then deformed to the open configuration. In the open configuration, the coupling 32 is in the first configuration. The property band 18 can then be mounted to the body 6 of the housing 4, this is shown in Figures 5a to 6a. As can be seen, the body 20 of the property band 18 passes over the body 6 of the housing 4 until the property band 18 is disposed about the body 6 of the housing 4. Figure 6a shows the property band 18 and the body 6 of the housing 4 with the property band 18 mounted onto the body 6 of the housing 4. At this stage, the coupling 32 remains in the first configuration. Once the body 20 of the property band 18 is mounted onto the body 6 of the housing 4, the first channel central axis (not shown) is generally coaxial with the second channel central axis (not shown).

As can be seen from Figure 6a, a gap 70 is disposed between the first coupling portion 34 and the second coupling portion 36. The coupling member 58 is then inserted into the coupling 32, as is shown in Figure 6b. Once the coupling member 58 is received by the coupling 32, the first end (not visible in Figure 6b) of the coupling member 58 is disposed in the first coupling portion 34 and the second end (not visible in Figure 6b) of the coupling member 58 is disposed in the second coupling portion 36. Once the coupling member 58 is received by the coupling 32, the central portion 64 of the coupling member 58 is disposed between the first coupling portion 34 and the second coupling portion 36. Once the coupling member 58 is received by the coupling 32, the protrusion 68 is disposed in the gap 70. Once the coupling member 58 is received by the coupling 32, the coupling 32 is in the second configuration. Receipt of the coupling member 58 by the coupling 32 prevents removal of the body 20 of the property band 18 from the body 6 of the housing 4. The property band 18 may advantageously be retrofitted onto existing measurement sensors.

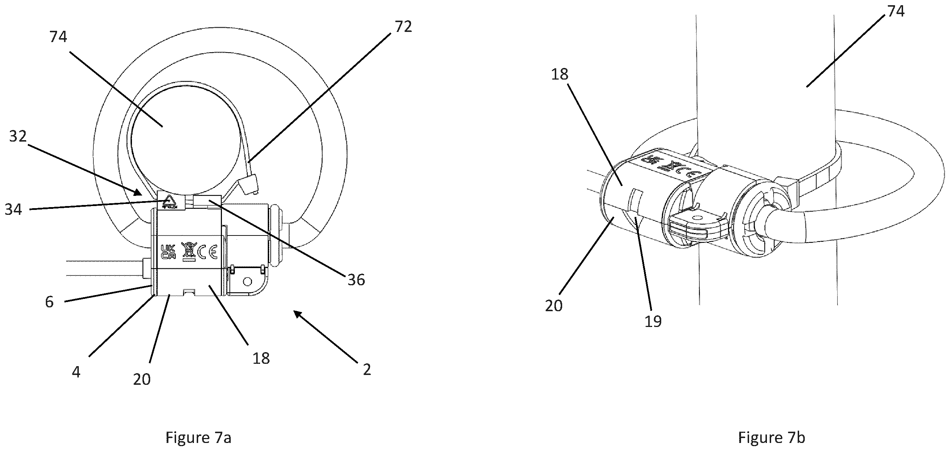

In the embodiment shown in Figures 7a and 7b an alternative coupling member 72 is provided. In Figures 7a and 7b, the coupling 32 is in the second configuration. Referring first to Figure 7a, the coupling member 72 of this embodiment is further configured to secure the body 20 of the indication band 18, and therefore the housing 4 of the measurement sensor 2, to a conductor 74. A coupling member 72 is in the form of a cable tie. However, it will be appreciated that other similar coupling members may be used in place of a cable tie. The coupling member 72 extends through the first channel (not visible in Figures 7a and 7b) of the first coupling portion 34 and through the second channel (not visible in Figures 7a and 7b) of the second coupling portion 36, around the conductor 74 and secures to itself. This secures the position of the measurement sensor 2, in particular the body 6 of the measurement sensor, with respect to the conductor 74. This also secured the coupling member 72 to the conductor. Advantageously, the coupling member of this embodiment is multi-purpose in that it allows the coupling 32 to be placed in the second configuration, and also secures the indication band 18, and therefore the measurement sensor 2, to the conductor 74. This allows the property band 18 to be more user friendly.

Figure 7b shows a side perspective view of this embodiment. As for the previous embodiment, the body 20 of the property band 18 of this embodiment comprises a polarity indication 19, which indicates the direction of conventional current flow withing the conductor.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. A property band that is mountable to a measurement sensor, the measurement sensor being for determining one or more characteristics of a conductor and comprising a housing and a cable, the property band comprising:
a body that is configured to be mounted to the housing of the measurement sensor; and
wherein the body comprises a coupling and wherein, in a first configuration of the coupling, the body is mountable to, or removable from, the housing, and, in a second configuration of the coupling, removal of the body from the housing is prevented.

2. The property band of claim 1, further comprising a coupling member, and wherein, in the second configuration, the coupling is configured to receive the coupling member to prevent removal of the body from the housing; wherein optionally
the coupling member is configured to secure the body to the conductor.

3. The property band of claim 2, wherein the coupling member and coupling together define a poka-yoke mechanism.

4. The property band of any preceding claim, wherein the body comprises a base portion, a first arm that extends from the base portion, and a second arm that extends from the base portion.

5. The property band of any preceding claim, wherein the coupling comprises a first coupling portion and a second coupling portion.

6. The property band of claim 5 when claim 5 is dependent upon claim 4, wherein the first coupling portion is disposed at a first arm distal end and the second coupling portion is disposed at a second arm distal end.

7. The property band of claim 5 or claim 6, wherein the first coupling portion comprises a first channel and the second coupling portion defines a second channel; and/or wherein
the first coupling portion defines a first end and a second end, wherein the first channel tapers between the first end and the second end.

8. The property band of claim 2 or claim 3 and any of claims 5 to 7, wherein the coupling member is in the form of a plug, a first end of the plug being receivable by the first coupling portion and a second end of the plug being receivable by the second coupling portion.

9. The property band of claim 8 when claim 8 is dependent upon claim 7, wherein a shape of the first end of the plug corresponds to a shape of the first channel.

10. The property band of claim 8 or claim 9, wherein the plug comprises a central portion that comprises a protrusion, a thickness of the plug at the protrusion being equal to or greater than a thickness of the second opening of the first coupling portion; wherein optionally
when received by the coupling, the protrusion is disposed between the first coupling portion and the second coupling portion.

11. The property band of any of claims 7 to 10, wherein, in the second configuration of the coupling, a first channel central axis is generally coaxial a second channel central axis.

12. The property band of any preceding claim, wherein the body is formed from a resilient material; and/or wherein
the property band provides an indication of a phase of the conductor, preferably a visual indication of the phase of the conductor; and/or wherein
a colour of the body of the property band provides an indication of the phase of the conductor; and/or wherein
the property band provides a visual indication of a polarity of a conductor.

13. A measurement sensor for measuring one or more characteristics of a conductor, the measurement sensor comprising:
a cable having a first end that extends from the housing and a free second end;
a housing that comprises a socket, the first end of the cable extending from the housing and the free second end of the cable being receivable by the socket; and
a property band according to any preceding claim, the property band being disposed about the housing.

14. A method comprising:
providing an electricity supply that comprises a plurality of conductors;
providing a measurement sensor that comprises a housing and a cable;
determining one or more properties of a conductor of the plurality of conductors;
mounting a property band to the housing of the measurement sensor, the property band being associated with the one or more properties of the conductor; and
securing the property band to the housing.

15. The method of claim 14, wherein securing the property band to the housing also secures the property band to the conductor.
